## Europäisches Patentamt

(19) **European Patent Office**

**Office européen des brevets**

(11) Publication number: **0 128 492**
**B1**

(12) **EUROPEAN PATENT SPECIFICATION**

(45) Date of publication of patent specification: **29.08.90**

(21) Application number: **84106312.6**

(22) Date of filing: **01.06.84**

(51) Int. Cl.⁵: **G 01 R 19/00,** G 01 R 19/22, G 01 R 19/25, H 02 M 1/08, **H 02 M 7/155**

(54) Method of measuring the D.C. level of the output of an A.C.-to-D.C. power converter.

(30) Priority: **03.06.83 JP 99675/83**

(43) Date of publication of application:
**19.12.84 Bulletin 84/51**

(45) Publication of the grant of the patent:
**29.08.90 Bulletin 90/35**

(84) Designated Contracting States:
**DE FR GB**

(56) References cited:
**DE-A-2 901 160**
**GB-A-1 276 138**

(73) Proprietor: **MITSUBISHI DENKI KABUSHIKI KAISHA**
**2-3, Marunouchi 2-chome Chiyoda-ku Tokyo 100 (JP)**

(72) Inventor: **Kawai, Joji c/o MITSUBISHI DENKI K.K.**
**Power and Ind. Systems Center 1-2, Wadasakicho**
**1 chome Hyogo-ku Kobe-shi Hyogo (JP)**

(74) Representative: **Eisenführ, Speiser & Strasse**
**Martinistrasse 24**
**D-2800 Bremen 1 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The invention relates to a method of measuring d.c. voltage and current components of the output of a d.c. output power converter including a ripple component related to the frequency of an a.c. power supply.

The output of an a.c.-to-d.c. power converter, such as a thyristor converter, includes a ripple component in the operating frequency of the switching elements such as thyristors, and therefore, a smoothing process is required for the detected d.c. output in order to eliminate the ripple component. Analog filters and digital filters are known as means for smoothing the d.c. output signal. However, such analog filters generally have a large time constant with respect to the ripple frequency, and therefore, it is difficult for the filter output to accomplish a high response rate control system for the converter. On the other hand, digital filters have a shortcoming that their operating parameters need to be set in accordance with each ripple frequency.

GB-A-12 76 138 relates to an analog to digital converter for converting an analog signal (which may include undesirable noise) to a corresponding digital output signal. Multiple samples are taken and converted into digital data in response to sampling pulses over a period of the expected noise component of the d.c. signal to be measured, and then the resulting values are scaled and accumulated to produce an arithmetic mean value.

It is an object of the present invention to provide a method as defined above, capable of accomplishing a high response rate control system having only a small time lag for the measurement.

The method according to the invention comprises the steps of:

a) selecting either the voltage or current component output of the power converter,

b) in response to each pulse of a train of pulses at a frequency which is N times that of the ripple frequency, where N is greater than 1, and in synchronism therewith, performing the following steps:

i) sampling the value of said selected output,

ii) converting said sample values into digital data, and storing said data in a memory,

iii) calculating a mean value of the most recent N values in a digital manner,

c) repeating steps a) and b) for the other component output, wherein said pulse train is generated by a phase-locked loop circuit which receives the frequency of the a.c. power supply to the converter as a reference input.

Fig. 1 is a schematic diagram of the thyristor converter to which the present invention is applied;

Fig. 2 is a set of waveform diagrams used to explain the measuring method according to the present invention;

Fig. 3 is a block diagram showing the measuring circuit for carrying out the method shown in Fig. 2; and

Figs. 4 and 5 are flowcharts explaining the inventive measuring method.

Description of the Preferred Embodiment

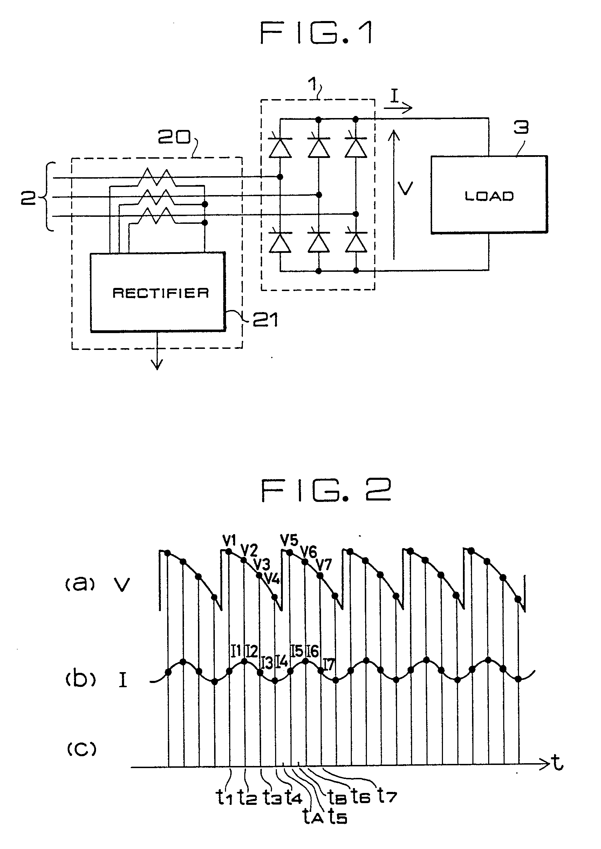

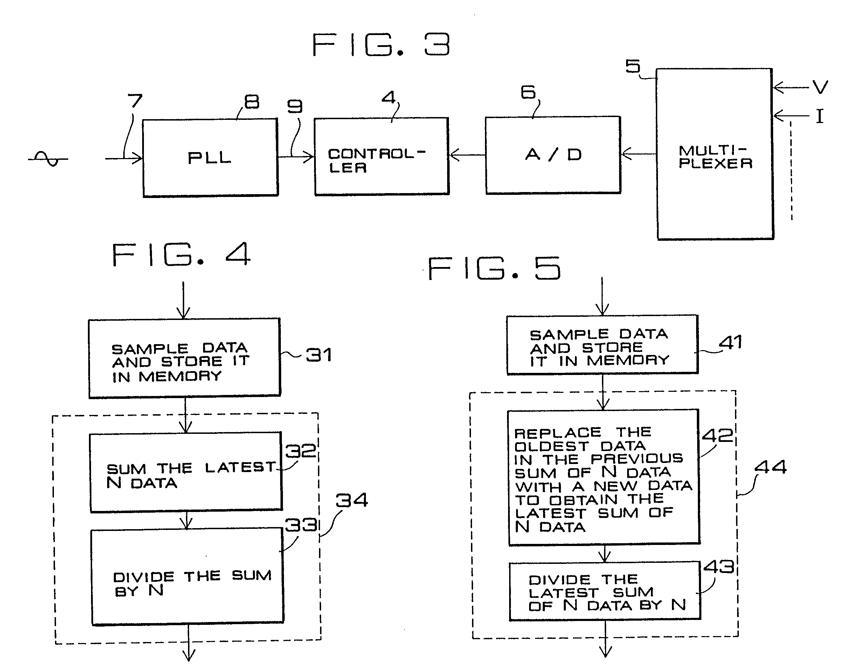

The present invention will now be described by way of embodiment with reference to the drawings. The thyristor converter system shown in the schematic diagram of Fig. 1 includes a thyristor converter 1, a 3-phase alternating power source 2 providing the input power to the converter 1, a load 3 to which the d.c. output of the converter 1 is supplied, a detector 20 for measuring the load current I on the a.c. input side of the converter 1, and a rectifying circuit 21 incorporated in the detector 20. The voltage V and current I on the load 3 include ripple components related to the frequency of the 3-phase a.c. power source 2 as shown by respective waveforms (a) and (b) in Fig. 2.

In Fig. 3 showing in block form one embodiment of the present invention, the measuring circuit includes a controller 4 incorporating a computational device such as a microprocessor, a multiplexer for selecting one of the analog signals representing the output voltage V and current I, an analog-to-digital (A/D) converter 6 for converting the analog signal selected by the multiplexer 5 into digital data to be supplied to the controller 4, and a phase locked loop (PLL) circuit 8. The controller 4 determines the firing phase of each thyristor to control the output voltage V and current I, and the PLL circuit 8 receives a signal 7 derived from one phase of the 3-phase a.c. power source 2 shown in Fig. 1 and provides pulses originating from the signal 7 with a multiplied frequency and carrying frequency information on the 3-phase a.c. power source 2 to be delivered to the controller 4 as periodic interrupt signals.

The operation of the measuring circuit shown in Fig. 3 will be described. An arbitrary phase of the 3-phase voltage of the input power source 2 is supplied in the form of the signal 7 to the PLL circuit 8. The PLL circuit 8 responds to the signal 7 in a frequency of f to produce synchronized pulses 9 at a frequency of 6Nf (N is an integer equal to or larger than 1). The role of the PLL circuit 8 is to produce pulses 9 at a frequency which is a multiple of the ripple frequency 6f included in the output voltage and current of the thyristor converter 1.

The following describes the case of N=4 as an example, and the generated pulses 9 are shown by (c) in Fig. 2. The controller 4 normally operates for the control of the thyristor converter 1, and when receiving a pulse 9 from the PLL circuit 8 it proceeds to the preprogrammed interrupt operation shown by the flowchart of Fig. 4, then returns to the original control process upon completion of the interrupt program. In the interrupt operation caused by the pulse 9, the controller 4 stores voltage or current data in the form of a binary digital signal in the memory within the controller 4. Generally, latest four pieces of data stored for each input signal 7 suffice for the following process (at least four data sampled over the period of the signal 7 suffice to provide the mean value of the output voltage or current). For example, at time point $t_A$ of Fig. 2, voltage data V1, V2, V3 and V4, and current data I1, I2, I3 and I4 are memorized. In a subsequent time point $t_B$, voltage data V2, V3, V4 and V5, and current data I2, I3, I4 and I5 are memorized.

The controller 4 sums the each set of four latest data and divides the results by four respectively to obtain the respective mean values. The resultant values represent the mean values of the magnitudes with respect to a reference level over a period of the voltage V and current I, and therefore, the ripple components are removed from the voltage and current levels.

The controller 4 carries out the sampling process 31 and averaging process 34 as shown in the flowchart of Fig. 4 each time it receives a pulse 9, and the mean values are used as data for the control of the thyristor converter 1.

In the case that a larger number (N) of samples is used or more signals need to be treated, that require a longer time for the process of summation 32, the sum of N data may be provided in such a way as shown by 42 of Fig. 5 that one oldest data is removed from the previous sum for N data and one newly sampled data is added to form the latest sum for N pieces of data. Alternatively, by choosing the value of N as $N=2^n$ ($n=1, 2, ...$), the division process 33 or 34 can be substituted by the truncation of the lowest n bits of the sum produced by the process 33 or 43. For dealing with a variety of signals, they may be sampled through the multiplexer 5 (Fig. 3) and processed as shown in Fig. 4 or 5 on a sequential basis, or the signals may be sampled at one time and thereafter processed sequentially.

The foregoing sampling, summing and averaging processes may be carried out by a dedicated processor provided separately from the thyristor converter controller.

By the provision of the sampled data memory with a capacity larger than N, a series of data for each signal in a time domain can be recorded and updated at a certain interval. Reading out of such data can reproduce approximate waveforms of the actual power output, allowing a historical record of the operation.

In the occurrence of a failure of the thyristor converter, troubleshooting is facilitated by halting the data sampling operation and analyzing data stored in the memory.

According to the present invention, as described above, the mean value of the d.c. output of a power converter can be obtained in a time lag smaller than the period of the input a.c. power frequency and without being affected by the ripple component. Even if the input power frequency varies, the use of the PLL circuit maintains the interrupt signal synchronized with the ripple frequency, and thus the control system is immune to the power frequency variation. In addition, the inventive method readily provides operational and diagnostic data for the power converter system.

## Claims

1. A method of measuring d.c. voltage and current components of the output of a d.c. output power converter including a ripple component related to the frequency of its a.c. power supply, wherein said method comprises the steps of:

a) selecting either the voltage or current component output of the power converter,

b) in response to each pulse of a train of pulses at a frequency which is N times that of the ripple frequency, where N is greater than 1, and in synchronism therewith, performing the following steps:

i) sampling the value of said selected output,

ii) converting said sample values into digital data, and storing said data in a memory,

iii) calculating a mean value of the most recent N values in a digital manner,

c) repeating steps a) and b) for the other component output, wherein said pulse train is generated by a phase-locked loop circuit which receives said frequency of said a.c. power supply as a reference input.

2. A method according to claim 1, wherein use is made of a microcomputer which operates in response to the output signal of the PLL, which microcomputer controls said selection of either voltage or current and uses said digital data to calculate the mean values of the output power.

## Patentansprüche

1. Verfahren zum Messen von Gleichspannungs- und Gleichstromkomponenten am Gleichspannungsausgang eines Leistungswandlers, wobei am Ausgang eine Welligkeit ansteht, die mit der Frequenz einer Wechselstromversorgung in Beziehung steht, gekennzeichnet durch die folgenden Verfahrensschritte:

a) daß entweder die Ausgangsspannungs- oder Ausgangsstromkomponente am Ausgang des Leistungswandlers ausgewählt wird,

b) daß abhängig von jedem Impuls einer Impulsfolge mit einer Frequenz, die N-mal so hoch wie die Frequenz der Welligkeit ist, wobei N größer als 1 ist, und synchron damit, die folgenden Schritt ausgeführt werden:

i) Abtasten des Wertes der ausgewählten Ausgangskomponente,

ii) Umwandeln der Abtastwerte in Digitalwerte und Abspeichern dieser Daten in einem Speicher, iii) Berechnen des Mittelwertes aus den letzten N-Werten in digitaler Weise,

c) Wiederholung der Verfahrensschritte a) und b) für die andere Ausgangskomponente, wobei die Impulsfolge durch eine PLL-Schaltung erzeugt wird, der die Frequenz der Wechselstromversorgung als Referenzeingang zugeführt wird.

2. Verfahren nach Anspruch 1, gekennzeichnet

EP 0 128 492 B1

durch die Benutzung eines Mikrocomputers, der abhängig vom Ausgangssignal der PLL-Schaltung arbeitet und die Auswahl entweder der Ausgangsspannungskomponente oder der Ausgangsstromkomponente steuert und die digitalen Daten dazu benutzt, um die Mittelwerte der Ausgangsleistung zu berechnen.

## Revendications

1. Procédé pour mesurer des composantes de tension continue et de courant continu du signal de sortie d'un convertisseur d'une puissance de sortie en courant continu incluant une composante d'ondulation associée à la fréquence de la source d'alimentation en énergie à courant alternatif de ce convertisseur, ledit procédé incluant les étapes consistant à:

a) sélectionner soit la composante de tension, soit la composante de courant délivrée par le convertisseur de puissance,

b) en réponse à chaque impulsion d'un train d'impulsions à une fréquence égale à N fois celle de la fréquence d'ondulation, N étant supérieur à 1, et en synchronisme avec cette fréquence, exécuter les étapes suivantes:

i) l'échantillonnage de la valeur dudit signal de sortie sélectionné,

ii) la conversion desdites valeurs échantillons en des données numériques et mémoriser lesdites données dans une mémoire,

iii) le calcul, selon un mode numérique, d'une valeur moyenne des N valeurs les plus récentes,

c) répéter les étapes a) et b) pour l'autre composante de sortie, ledit train d'impulsions étant produit par un circuit à boucle de verrouillage de phase, qui reçoit ladite fréquence de ladite source d'alimentation en énergie à courant alternatif en tant que signal d'entrée de référence.

2. Procédé selon la revendication 1, selon lequel on utilise un micro-ordinateur qui fonctionne en réponse au signal de sortie de la boucle PLL, lequel micro-ordinateur commande ladite sélection soit de la tension, soit du courant et utilise lesdites données numériques pour calculer les valeurs moyennes de la puissance de sortie.

# EP 0 128 492 B1

## FIG.1

## FIG. 2

1

# FIG. 3

7 → PLL 8 — 9 → CONTROL-LER 4 ← A/D 6 ← MULTI-PLEXER 5 ← V ← I

# FIG. 4

SAMPLE DATA AND STORE IT IN MEMORY — 31

SUM THE LATEST N DATA — 32

DIVIDE THE SUM BY N — 33

34

# FIG. 5

SAMPLE DATA AND STORE IT IN MEMORY — 41

REPLACE THE OLDEST DATA IN THE PREVIOUS SUM OF N DATA WITH A NEW DATA TO OBTAIN THE LATEST SUM OF N DATA — 42

DIVIDE THE LATEST SUM OF N DATA BY N — 43

44

EP 0 128 492 B1